# FASCICULE DE BREVET EUROPEEN

(11) **EP 2 567 417 B1**
(45) Date de publication et mention de la délivrance du brevet: **12.08.2015**
(21) Numéro de dépôt: 11723570.5
(22) Date de dépôt: 05.05.2011
(51) Int. Cl.: H01L 41/083, H01L 41/277, H01L 41/293, F02M 51/06, F02M 69/04, F02M 61/08, H01L 41/047

(54) **PROCEDE DE FABRICATION D'UN ACTIONNEUR A EMPILEMENT DE COUCHES ALTERNEES D'ELECTRODE INTERCALAIRE ET DE MATERIAU PIEZOELECTRIQUE**
VERFAHREN ZUR HERSTELLUNG EINES AKTUATORS MIT EINEM STAPEL AUS SICH ABWECHSELNDEN ELEKTRODENZWISCHENSCHICHTEN UND SCHICHTEN AUS PIEZOELEKTRISCHEM MATERIAL
PROCESS FOR PRODUCING AN ACTUATOR HAVING A STACK OF ALTERNATING INTERMEDIATE ELECTRODE LAYERS AND PIEZOELECTRIC MATERIAL LAYERS

(30) Priorité: 06.05.2010 FR 1053545
(43) Date de publication de la demande: 13.03.2013
(73) Titulaire: Renault S.A.S., 92100 Boulogne-Billancourt (FR)
(72) Inventeur: MALEK, Nadim, F-78000 Versailles (FR); LEVIN, Laurent, F-75015 Paris (FR)
(86) Numéro de dépôt international: PCT/FR2011/051019
(87) Numéro de publication internationale: WO 2011/138562

(56) Documents cités:
- EP-A1- 1 172 552
- EP-A1- 1 855 329
- WO-A1-2008/025315
- DE-C1- 19 626 671
- FR-A1- 2 862 161
- US-A- 5 381 385
- US-A1- 2004 251 784

## Description

La présente invention a pour objet un procédé de fabrication d'un actionneur à base de matériaux piézoélectriques, et plus particulièrement d'un actionneur comportant au moins un empilement de couches d'électrode et de couches de matériau piézoélectrique. Cet actionneur peut être utilisé dans un injecteur de fluide, comme un injecteur de carburant pour l'industrie automobile.

Les injecteurs de carburant servent à pulvériser très finement le carburant afin d'améliorer la combustion et de réduire les émissions polluantes. L'injecteur de fluide piézoélectrique à fréquence ultrasonore permet de contrôler la pénétration de carburant dans la chambre de combustion, rendant ainsi possible le fonctionnement en mélange pauvre ou stratifié.

L'injecteur de fluide à fréquence ultrasonore piézoélectrique ou magnétostrictif peut être utilisé pour injecter :
- du gazole ou tout autre carburant dans des moteurs Diesel à injection directe ou à préchambre,
- de l'essence ou tout autre carburant dans des moteurs dits à essence à injection directe ou indirecte,
- tout autre carburant dans un moteur à combustion interne, ou dans une turbine à gaz ou autre,
- tout type de fluide pour la régénération de systèmes de dépollution, comme par exemple un piège à oxyde d'azote, un piège à particules communément appelé filtre à particules (FAP).

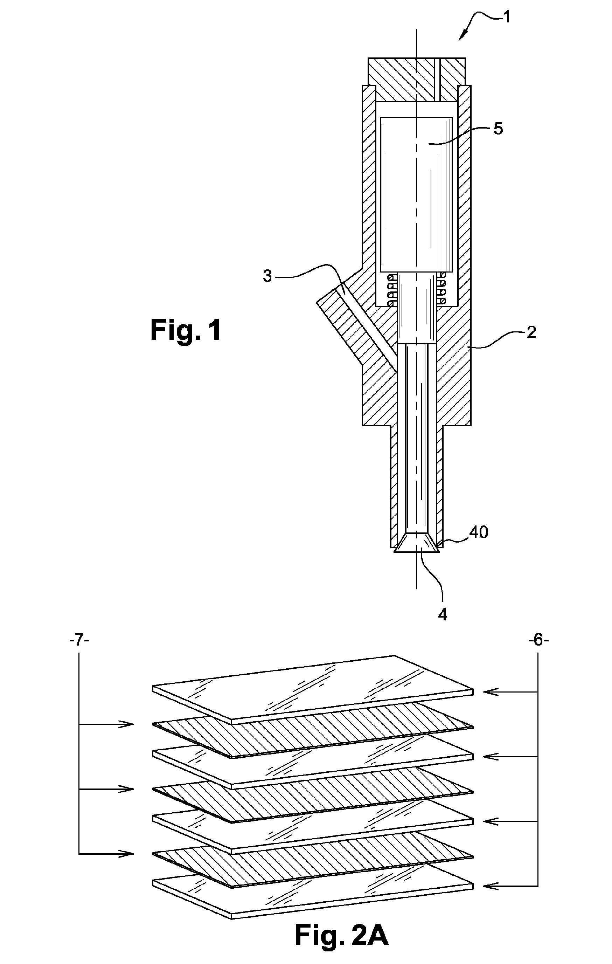

L'injecteur ultrasonore réalise la pulvérisation d'un fluide en fractionnant la nappe de fluide. Un tel injecteur 1, est illustré à la figure 1. L'injecteur 1 est muni d'un corps d'injecteur 2, et d'une entrée 3 de fluide par laquelle le fluide entre sous haute pression. L'injecteur 1 fait passer la nappe de fluide à travers un dispositif mécanique oscillant qui est une ouverture obtenue par l'éloignement d'une tête d'aiguille 4 de son siège 40. Cette ouverture s'ouvre et se referme à une fréquence ultrasonore. L'excitation mécanique est fournie par un empilement 5 de céramiques piézoélectriques ou par un barreau de matériau magnétostrictif ou un matériau ayant des propriétés semblables. Ces matériaux électro-actifs sont alimentés par des générateurs électriques adaptés.

La suite de la description est consacrée à l'ensemble actif, c'est-à-dire à l'actionneur, qui comprend l'empilement de couches de matériau piézoélectrique. Cet ensemble actif sera aussi bien utilisable pour un injecteur à tête entrante que pour un injecteur à tête sortante.

Les empilements de céramiques piézoélectriques se présentent classiquement sous deux formes.

On connaît d'une part des empilements de couches de céramiques épaisses, typiquement de 1 à 5 mm d'épaisseur unitaire, sous forme d'anneau ou de disques percés, avec une vis de précontrainte traversant axialement l'empilement, avec des électrodes intercalaires constituées d'un alliage métallique de quelques dizaines ou centaines de µm. Cet assemblage pose un problème technico-économique en production industrielle.

En effet, pour avoir une parfaite reproductibilité, ce type de montage nécessite des usinages supplémentaires liés au perçage des pièces pour le passage de la vis de précontrainte. Ce type de montage nécessite également d'avoir une planéité dans une tolérance submicronique sur chaque face de chaque céramique et de chaque électrode intercalaire imposant un rodage soigné double face de chaque pièce avant montage dans l'empilement.

On connaît d'autre part des empilement de couches de céramiques de faible épaisseur unitaire, typiquement de l'ordre de 100 µm (micromètres ou microns), et comportant des électrodes intercalaires d'une épaisseur de quelques µm, par exemple de l'ordre de 5 µm, réalisées par dépôt sur la céramique. Dans ce cas, la connexion des électrodes intercalaires avec les électrodes de connexion se fait par exemple par l'application d'un polymère chargé en matériau conducteur, et la surface de contact avec une électrode intercalaire se fait alors localement sur une hauteur de quelques µm, par exemple 5 µm. Cet assemblage amène comme problèmes d'une part des difficultés de réalisation de la connexion et d'autre part une fragilité mécanique de cette connexion dans la zone de contact qui ne dépasse pas les 5 µm. Cet assemblage est donc peu adapté à la génération d'ultrasons de puissance et résiste mal à la présence d'hydrocarbures liquides ou gazeux à cause de la réaction chimique du polymère conducteur avec le carburant.

Des dispositifs et des procédés connus sont décrits par US 2004 / 0251784 A1, US 5 381 385, WO 2008 / 025315 A1, DE 196 26 671 C1, EP 1 172 552 A1, FR 2 862 161 A1 et EP 1 855 329 A1.

Les ultrasons de puissance sont générés par des déplacements alternatifs à fréquence ultrasonore (typiquement entre 10 kHz et 100 kHz), de fortes amplitudes (de l'ordre de plus ou moins 5 à 10 µm) et fortes contraintes (de l'ordre de plus ou moins 40 MPa). Un problème lié à ces ultrasons de puissance est qu'ils peuvent générer des contraintes de cisaillement importantes au niveau de la jonction où se fait le contact électrique entre l'électrode intercalaire et l'électrode de connexion.

L'invention a pour objectif de remédier à ces inconvénients.

L'invention propose en particulier un procédé qui permet de fabriquer de manière simple et économique et avec une grande précision un actionneur à empilement de couches épaisses d'électrode et de matériau piézoélectrique

L'invention a ainsi pour objet un procédé de fabrication d'un actionneur adapté à la génération d'ultrasons de puissance et comportant un empilement de couches alternées d'électrode intercalaire et de matériau piézoélectrique.

Le procédé selon l'invention comprend les étapes définies par la revendication 1.

L'étape de solidarisation des couches adjacentes entre elles est avantageusement une étape de collage ou de brasage.

Le procédé peut comprendre une étape de connexion par soudage d'électrodes de connexion aux faces apparentes correspondantes des couches d'électrode intercalaire. Les couches d'électrode intercalaire peuvent posséder une épaisseur de quelques centaines de microns. L'épaisseur des couches d'électrode intercalaire peut ainsi être comprise entre 100 µm et 1 mm.

Les échancrures des couches de matériau piézoélectrique de l'empilement initial peuvent être obtenues par découpage des couches de matériau piézoélectrique au niveau de perforations réalisées dans les couches de matériau piézoélectrique.

Les perforations des couches de matériau piézoélectrique de l'empilement initial sont de préférence circulaires.

Les perforations peuvent être réalisées par perçage.

Les extrémités respectives munies d'échancrures de deux couches successives d'électrode intercalaire de l'empilement initial sont avantageusement opposées.

D'autres caractéristiques et avantages de la présente invention apparaîtront plus clairement à la lecture de la description suivante donnée à titre d'exemple illustratif et non limitatif et faite en référence aux dessins annexés sur lesquels :
- la figure 1, déjà décrite, illustre un injecteur de carburant,
- les figures 2A à 2G illustrent différentes étapes d'un procédé de fabrication d'un actionneur et
- les figures 3A à 3F illustrent différentes étapes d'un procédé de ) fabrication d'un actionneur selon l'invention, conformément à un mode de réalisation.

Au début du procédé, il convient de pré-assembler les céramiques piézoélectriques et les électrodes intercalaires en ayant pris le soin de bien aligner correctement l'empilement de céramiques et d'électrodes. Ceci se traduit par la réalisation d'un monobloc multicouche de céramiques épaisses (quelques millimètres) et d'électrodes intercalaires (quelques centaines de µm). Les céramiques doivent être empilées alternativement avec des électrodes intercalaires afin de pouvoir être excitées à l'aide d'un champ électrique appliqué dans chacune des couches de céramique. Le champ électrique résulte de l'application d'une tension électrique aux bornes de deux électrodes intercalaires sur les deux faces opposées de ladite couche de céramique.

Tel qu'illustré à la figure 2A, le procédé débute par un empilement de grandes plaques 6 de céramiques piézoélectriques et de grandes feuilles 7 d'électrodes intercalaires.

Les plaques 6 de céramiques piézoélectriques peuvent avoir des dimensions typiquement de 150 mm x 100 mm et des épaisseurs allant de 1 mm à 5 mm.

Les électrodes intercalaires 7 peuvent être des feuilles métalliques de dimensions 150 mm x 100 mm et des épaisseurs pouvant être de préférence comprises entre 100 µm et 1 mm. Les matériaux sont typiquement un alliage de cuivre, de titane, ou d'argent.

Le choix du matériau métallique dépend des paramètres à optimiser, comme par exemple la transmission acoustique, la réduction des contraintes aux interfaces de brasage ou de collage, la facilité de connexion des électrodes intercalaires avec les électrodes de connexion.

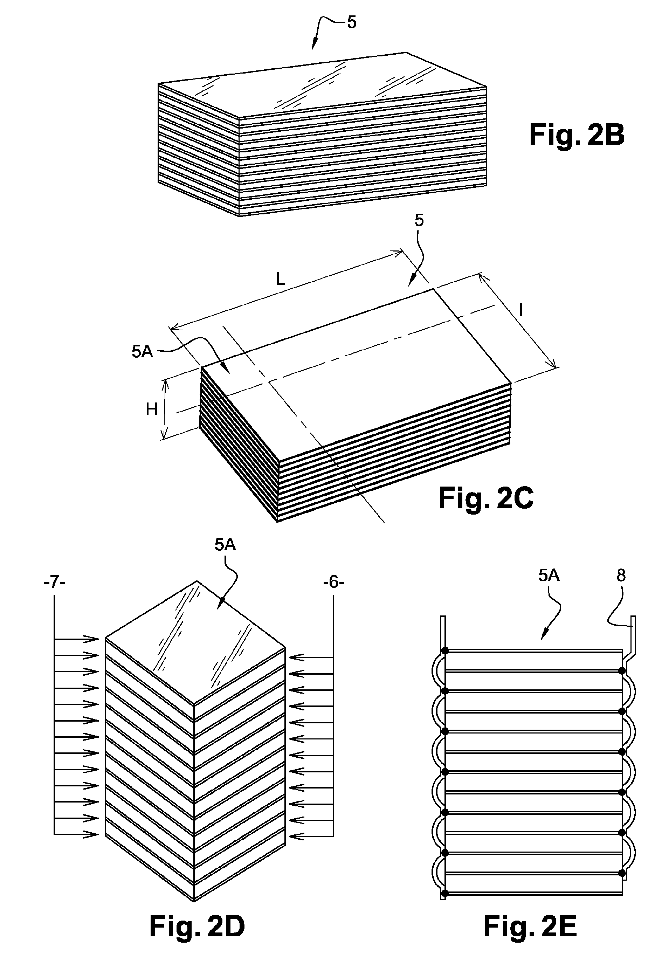

Dans une deuxième étape, tel qu'illustré à la figure 2B, on procède au brasage ou au collage de l'empilement 5, de manière à obtenir un parallélépipède 5.

Le parallélépipède 5 peut être rectifié sur ses six plans pour obtenir une forme géométrique quasi parfaite. Les dimensions de ce parallélépipède 5 peuvent être typiquement 150 mm x 100 mm avec une hauteur de 40 mm.

Les dimensions et les formes du parallélépipède 5, et des plaques 6 de céramiques piézoélectriques et des feuilles 7 d'électrode intercalaire sont données à titre d'exemple et ne sont pas limitatives. On peut utiliser par exemple des plaques et des feuilles de section carrée de 100 mm x 100 mm.

La brasure ou le collage est un procédé d'assemblage qui permet d'agir comme bouche-trou et de rattraper les défauts de planéité et d'éviter ainsi un rodage double face ultra fin des plaques 6 de céramique piézo-électrique et des feuilles 7 d'électrode intercalaire. Un autre avantage de la solidarisation des plaques et des feuilles est qu'il n'est pas nécessaire d'avoir recours à des moyens de bridage lors de la manipulation ultérieure du parallélépipède 5 dans un premier temps, puis des blocs élémentaires 5A dans un deuxième temps.

On procède ensuite à la découpe du parallélépipède 5 pour obtenir des blocs élémentaires 5A. Ces blocs élémentaires 5A ont des dimensions de préférence adaptées à la réalisation d'un actionneur apte à générer des ultrasons de puissance pour un injecteur ultrasonore tel que décrit ci-dessus, soit de l'ordre de 15 mm x 15 mm x 40 mm (figure 2C). Dans un autre exemple non limitatif, les dimensions peuvent être de 20 mm x 20 mm x 40 mm.

La figure 2D montre un empilement élémentaire 5A de section carrée, par exemple de 15 mm par 15 mm résultant de la découpe du parallélépipède 5 brasé ou collé.

Afin de connecter les électrodes intercalaires 7 entre elles de manière à obtenir le champ électrique dans chacune des couches 6 de céramique piézo-électrique, et de récupérer les déplacements induits par chacune des couches 6 de céramiques en phase, il est nécessaire de faire appel à des électrodes de connexion 8.

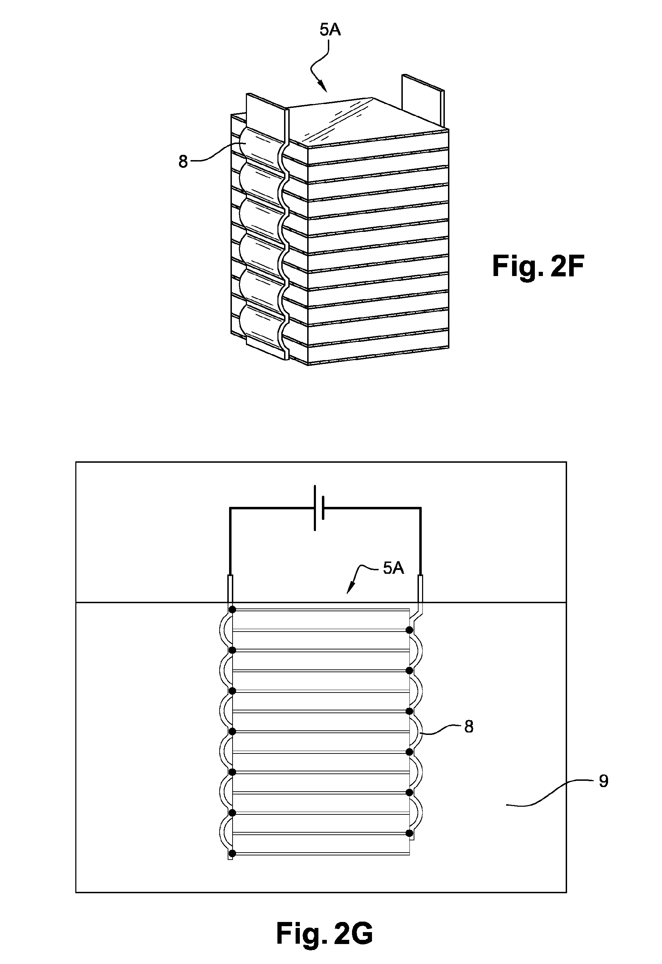

Un exemple est illustré aux figures 2E, 2F et 2G.

Conformément à cet exemple, les électrodes de connexion 8 sont de type ondulé, avec des méplats réalisés au niveau des contacts avec les électrodes intercalaires 7. Les électrodes de connexion 8 sont soudées aux électrodes intercalaires 7 à l'aide par exemple d'un faisceau laser. Le contact entre les électrodes intercalaires 7 et les électrodes de connexion 8 se fait sur les faces apparentes des électrodes intercalaires 7. Le contact et la soudure laser sont rendus possibles grâce à l'usage d'une électrode intercalaire 7 d'une épaisseur de quelques centaines de µm, de préférence comprise entre 100 µm et 1 mm. Cette épaisseur est à comparer aux épaisseurs des électrodes intercalaires très fines de quelques µm employées dans les empilements multicouches et qui sont connectées aux électrodes de connexion à l'aide d'une colle conductrice. En effet, l'utilisation des soudures par exemple par point entre les électrodes intercalaires 7 et les électrodes de connexion 8 entraîne une tenue mécanique de jonction, notamment une tenue aux contraintes de cisaillement, qui est très nettement améliorée et qui adaptée aux ultrasons de puissance. La soudure peut être réalisée par points sur tout ou partie de la surface de contact entre l'électrode intercalaire 7 et l'électrode de connexion 8.

L'empilement complet assemblé est illustré à la figure 2F.

Dans le cas d'une solidarisation par brasage, le procédé peut s'achever de préférence avec une étape de polarisation de l'empilement élémentaire 5A suivant les techniques connues de l'homme de l'art. Cette opération se déroule en appliquant une tension électrique appropriée et en baignant l'empilement dans une huile diélectrique 9 qui est portée à une température adéquate (figure 2G). cet exemple,

Dans cet exemple, on voit que les connexions entre les électrodes intercalaires 7 et les électrodes de connexion 8 se font par un méplat et que les électrodes de connexion 8 ont une forme adaptée pour être suffisamment éloignées des électrodes intercalaires 7 portées au potentiel opposé, de manière à empêcher la formation d'un arc électrique, d'un court-circuit. Sur les figures 2E, 2F et 2G, cette forme adaptée est une forme ondulée qui est disposée entre deux méplats.

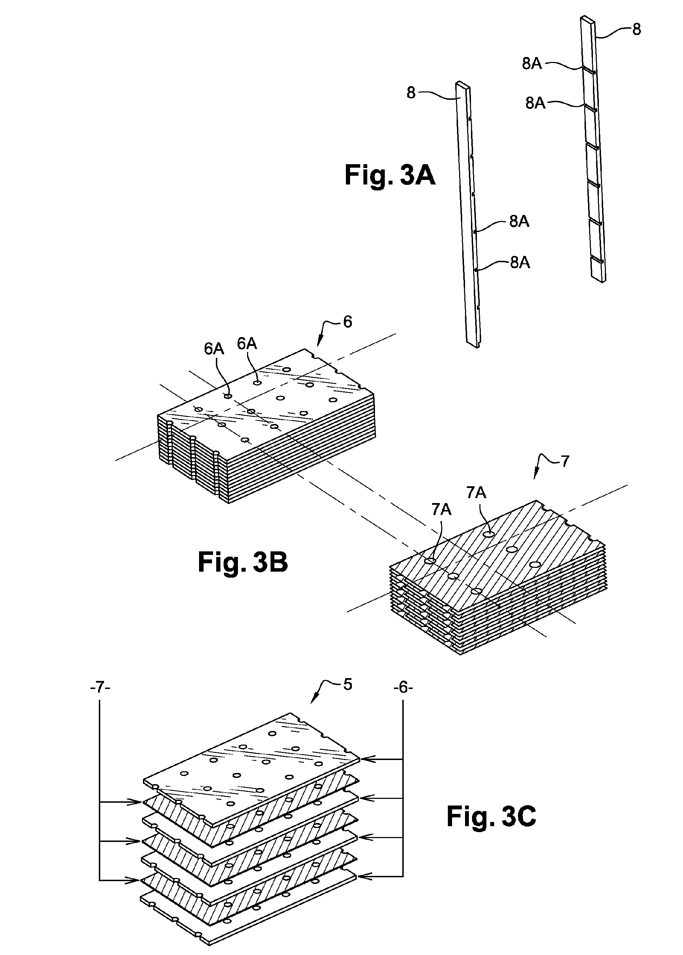

Un mode de réalisation de l'invention est représenté sur les figures 3A à 3F. Dans ce mode de réalisation, on peut envisager de faire appel à des électrodes de connexion 8 rectilignes épaisses et entaillées au niveau de chaque électrode intercalaire 7, tel qu'illustré à la figure 3A. Ce type d'électrode de connexion 8 permet d'obtenir des blocs élémentaires 5A d'actionneur qui sont plus compacts. Les entailles 8A permettent d'accroître la surface de contact entre les électrodes de connexion 8 et les électrodes intercalaires 7. Les entailles 8A correspondent de préférence à des rainures réalisées sur toute la largeur de l'électrode de connexion 8.

Pour connecter une électrode de connexion 8 aux électrodes intercalaires 7 au niveau des entailles 8, il est nécessaire de réaliser des échancrures 6B sur les faces de toutes les couches 6 de céramiques piézoélectriques qui sont en regard des électrodes de connexion 8.

Afin d'avoir une distance suffisante entre une électrode de connexion 8 et les électrodes intercalaires 7 portées au potentiel opposé, il est en outre nécessaire d'effectuer des échancrures 7B sur les faces de ces électrodes intercalaires 7 qui sont en regard de cette électrode de connexion 8. On empêche ainsi la formation d'un arc électrique ou d'un court-circuit entre l'électrode de connexion 8 et les électrodes intercalaires 7 portées au potentiel opposé.

Les échancrures 6B et/ou 7B peuvent par exemple ressembler à des demi-cercles. Ces demi-cercles peuvent être le résultat du découpage de trous ou perforations. Dans ce mode de réalisation, le procédé de fabrication de l'actionneur peut alors comporter une étape de perçage des plaques 6 de matériau piézoélectrique et des feuilles 7 d'électrode intercalaire.

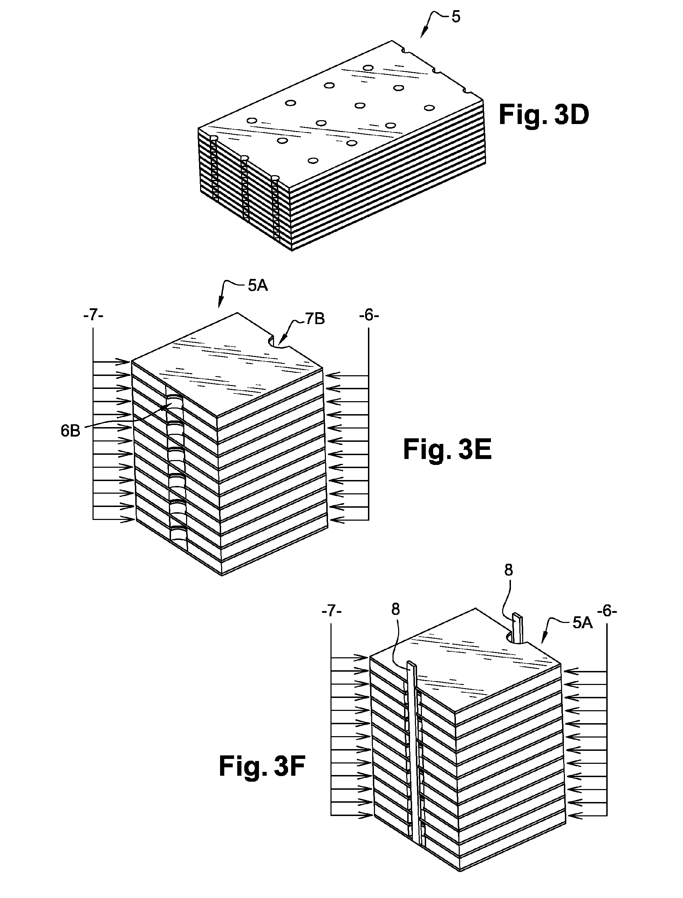

Conformément aux figures 3B, 3C et 3D, les trous 6A sont réalisés sur les plaques 6 de céramique piézoélectrique. On a une série de trous 6A selon la largeur de la plaque 6. Les centres de ces trous 6A sont espacés entre eux d'une distance sensiblement égale à la largeur du bloc élémentaire 5A obtenu après découpe du parallélépipède 5. Cette série de trous 6A est ensuite reproduite dans le sens de la longueur de la plaque 6 avec un espacement sensiblement égal à la largeur du bloc élémentaire 5A obtenu après découpe. L'espacement est défini entre les axes de chaque série qui passent par le centre des trous 6A.

Les trous 7A sont réalisés de la même façon sur les feuilles 7 d'électrodes intercalaires pour former une série de trous selon la largeur de la feuille 7. Cette série de trous 7A est cependant reproduite avec un espacement double dans le sens de la longueur de la feuille 7.

L'exemple correspond à la réalisation de blocs élémentaires 5A de section carrée. Il va de soi que cet exemple n'est en aucun cas limitatif et que l'homme du métier saura adapter la position des trous en relation avec le type de section des blocs élémentaires à réaliser.

On effectue des trous 6A et 7A disposés dans les plaques de céramique 6 ainsi que dans les feuilles d'électrodes intercalaires 7. On assemble de manière alternée ces plaques 6 et ces feuilles 7 par brasage ou par collage, puis on procède au découpage du parallélépipède 5 en passant par le centre des trous 6A dans le sens de la largeur du parallélépipède 5.

La figure 3B illustre le perçage des plaques 6 de céramiques piézoélectriques et des électrodes intercalaires 7. Les plaques de céramique 6 présentent ainsi des trous 6A, tandis que les électrodes intercalaires 7 présentent des trous 7A. Les feuilles d'électrodes intercalaires 7 ont ainsi deux fois moins de trous que les plaques de céramiques 6 selon la longueur des plaques. De plus, deux feuilles d'électrodes intercalaires 7 successives sont obtenues par retournement l'une de l'autre d'un demi-tour. Ceci a pour avantage de fabriquer des feuilles d'électrodes intercalaires 7 identiques et de les retourner alternativement pour préparer l'empilement.

On alterne ensuite les plaques 6 de céramiques piézoélectriques et les feuilles 7 d'électrodes intercalaires, de manière à former l'empilement 5 (figure 3C). Après brasure ou collage, on obtient un parallélépipède 5 (figure 3D) qui est découpé en empilements élémentaires 5A (figure 3E). On effectue des découpes selon des axes passant par le centre des trous 6A des plaques 6 de céramique dans le sens de la largeur, et des découpes selon des axes passant au milieu des rangées de trous 6A parallèles à la longueur.

On positionne ensuite les électrodes de connexion 8 entaillées sur les électrodes intercalaires 7 au niveau des entailles 8A et on effectue la soudure, par exemple par faisceau laser, au niveau de la surface de contact entre les entailles 8A et les électrodes intercalaires 7. On obtient ainsi un empilement monobloc élémentaire 5A connecté, tel qu'illustré à la figure 3F. Le soudage par faisceau laser n'est pas limitatif, et tout mode de soudage approprié et connu de l'homme de l'art pourra être utilisé.

La dernière opération peut consister à polariser l'empilement suivant les techniques connues de l'homme de l'art, notamment en cas de solidarisation par brasage.

Cette opération se déroule en appliquant une tension électrique appropriée et en baignant l'empilement dans une huile diélectrique et portée à une température adéquate comme décrit plus haut.

Il peut arriver que la section carrée du bloc élémentaire 5A ne soit pas adaptée et qu'il faille utiliser une section circulaire. Dans cette variante propre à ce mode de réalisation, en partant du bloc élémentaire 5A avec les échancrures et avant la soudure des électrodes de connexion, il suffit de tourner le bloc 5A de section carrée sur une machine d'usinage pour le transformer en monobloc à section circulaire. Les entailles des électrodes de connexion peuvent être d'une forme adaptée à ces électrodes intercalaires en forme de disque.

Dans ce cas, les échancrures sont un atout pour autoriser un contact des électrodes intercalaires avec les électrodes de connexion. La qualité des contacts est alors identique à celle obtenue avec un monobloc élémentaire de section carrée.

## Revendications

1. Procédé de fabrication d'un actionneur (5) adapté à la génération d'ultrasons de puissance et comportant un empilement de couches alternées d'électrode intercalaire (7) et de matériau piézoélectrique (6), comprenant :
- une étape de formation d'un empilement initial (5) de couches alternées d'électrode intercalaire (7) et de matériau piézoélectrique (6), chaque extrémité de l'empilement (5) étant une couche de matériau piézoélectrique (6) ou d'électrode intercalaire (7) ;
- une étape de solidarisation des couches adjacentes (6,7) entre elles ;
- une étape de découpage de l'empilement initial (5) en blocs élémentaires (5A) ; et,
- une étape de connexion des couches d'électrode intercalaire (7) entre elles, dans chaque bloc élémentaire (5A)
**caractérisé en ce que**
les couches d'électrode intercalaire (7) sont connectées entre elles à l'aide d'électrodes de connexion (8) présentant des entailles (8A) destinées à recevoir les couches d'électrode intercalaire (7) des blocs élémentaires (5A), des électrodes de connexion (8) étant positionnées au moins en partie dans des échancrures (6B) des couches de matériau piézoélectrique (6) de l'empilement initial (5), les couches de matériau piézoélectrique (6) de l'empilement initial (5) présentant deux extrémités opposées munies d'échancrures (6B) et les couches d'électrode intercalaire (7) de l'empilement initial (5) présentant une seule extrémité munie d'échancrures (7B).

2. Procédé selon la revendication 1, **caractérisé en ce que** l'étape de solidarisation des couches adjacentes (6,7) entre elles est une étape de collage ou de brasage.

3. Procédé selon l'une des revendications 1 ou 2, **caractérisé en ce que** l'épaisseur des couches d'électrode intercalaire (7) est comprise entre 100 µm et 1 mm.

4. Procédé selon l'une quelconque des revendications 1 à 3, **caractérisé en ce que** les échancrures (6B) des couches de matériau piézoélectrique (6) de l'empilement initial (5) sont obtenues par découpage des couches de matériau piézoélectrique (6) au niveau de perforations (6A) réalisées dans les couches de matériau piézoélectrique (6).

5. Procédé selon la revendication 4, **caractérisé en ce que** les perforations (6A) des couches de matériau piézoélectrique (6) de l'empilement initial (5) sont circulaires.

6. Procédé selon la revendication 5, **caractérisé en ce que** les perforations (6A) sont réalisées par perçage.

7. Procédé selon l'une quelconque des revendications 1 à 6, **caractérisé en ce que** les extrémités respectives munies d'échancrures (7B) de deux couches successives d'électrode intercalaire (7) de l'empilement initial (5) sont opposées.

## Patentansprüche

1. Verfahren zur Herstellung eines Aktuators (5), der zur Erzeugung von Leistungsultraschall angepasst ist und einen Stapel aus sich abwechselnden Elektrodenzwischenschichten (7) und Schichten aus piezoelektrischem Material (6) aufweist, das Folgendes aufweist:
- einen Schritt zum Bilden eines Ausgangsstapels (5) aus sich abwechselnden Elektrodenzwischenschichten (7) und Schichten aus piezoelektrischem Material (6), wobei jedes Ende des Stapels (5) eine Schicht aus piezoelektrischem (6) oder Zwischenelektrodenmaterial (7) ist;
- einen Schritt zur Verbindung benachbarter Schichten (6, 7) untereinander;
- einen Schritt zum Schneiden des Ausgangsstapels (5) in Elementarblöcke (5A); und
- einen Schritt zum Anschließen von Elektrodenzwischenschichten (7) untereinander in jedem Elementarblock (5A)
**dadurch gekennzeichnet, dass**
die Elektrodenzwischenschichten (7) untereinander mittels Anschlusselektroden (8) angeschlossen werden, die Einschnitte (8A) aufweisen, die dazu bestimmt sind, die Elektrodenzwischenschichten (7) der Elementarblöcke (5A) aufzunehmen, wobei Anschlusselektroden (8) mindestens teilweise in Ausschnitten (6B) der Schichten aus piezoelektrischem Material (6) des Ausgangsstapels (5) positioniert sind, wobei die Schichten aus piezoelektrischem Material (6) des Ausgangsstapels (5) zwei entgegengesetzte Enden aufweisen, die mit Ausschnitten (6B) versehen sind, und die Elektrodenzwischenschichten (7) des Ausgangsstapels (5) ein einziges Ende aufweisen, das mit Ausschnitten (7B) versehen ist.

2. Verfahren nach Anspruch 1, **dadurch gekennzeichnet, dass** der Schritt des Verbindens der benachbarten Schichten (6, 7) untereinander ein Schritt zum Kleben oder Löten ist.

3. Verfahren nach einem der Ansprüche 1 oder 2, **dadurch gekennzeichnet, dass** die Dicke der Elektrodenzwischenschichten (7) zwischen 100 µm und 1 mm enthalten ist.

4. Verfahren nach einem der Ansprüche 1 bis 3, **dadurch gekennzeichnet, dass** die Ausschnitte (6B) der Schichten aus piezoelektrischem Material (6) des Ausgangsstapels (5) durch Schneiden der Schichten aus piezoelektrischem Material (6) im Bereich von Lochungen (6A) erhalten werden, die in den Schichten aus piezoelektrischem Material (6) ausgeführt werden.

5. Verfahren nach Anspruch 4, **dadurch gekennzeichnet, dass** die Lochungen (6A) der Schichten aus piezoelektrischem Material (6) des Ausgangsstapels (5) kreisförmig sind.

6. Verfahren nach Anspruch 5, **dadurch gekennzeichnet, dass** die Lochungen (6A) durch Bohren ausgeführt werden.

7. Verfahren nach einem der Ansprüche 1 bis 6, **dadurch gekennzeichnet, dass** die entsprechenden Enden, die mit Ausschnitten (7B) von zwei aufeinanderfolgenden Elektrodenzwischenschichten (7) des Ausgangsstapels (5) versehen sind, entgegengesetzt sind.

## Claims

1. Process for manufacturing an actuator (5) suited to generating power ultrasound and comprising a stack of alternate intermediate electrode (7) and piezoelectric material (6) layers, comprising:
- a step of forming an initial stack (5) of alternate intermediate electrode (7) and piezoelectric material (6) layers, each end of the stack (5) being a piezoelectric material (6) or intermediate electrode (7) layer;
- a step of securely joining adjacent layers (6, 7) together;
- a step of cutting the initial stack (5) into elementary units (5A); and
- a step of connecting the intermediate electrode layers (7) of each elementary unit (5A) together.
**characterized in that**
the intermediate electrode layers (7) are connected together using connection electrodes (8) comprising notches (8A) intended to receive the intermediate electrode layers (7) of the elementary units (5A), the connection electrodes (8) being positioned at least in part in indents (6B) in the piezoelectric material layers (6) of the initial stack (5), the piezoelectric material layers (6) of the initial stack (5) having two opposite ends provided with indents (6B) and the intermediate electrode layers (7) of the initial stack (5) having a single end provided with indents (7B).

2. Process according to Claim 1, **characterized in that** the step of securely joining adjacent layers (6, 7) together is a step of adhesive bonding or soldering.

3. Process according to either of Claims 1 and 2, **characterized in that** the intermediate electrode layers (7) are between 100 µm and 1 mm in thickness.

4. Process according to in any one of Claims 1 to 3, **characterized in that** the indents (6B) in the piezoelectric material layers (6) of the initial stack (5) are obtained by cutting the piezoelectric material layers (6) through perforations (6A) produced in the piezoelectric material layers (6).

5. Process according to Claim 4, **characterized in that** the perforations (6A) in the piezoelectric material layers (6) of the initial stack (5) are circular.

6. Process according to Claim 5, **characterized in that** the perforations (6A) are obtained by drilling.

7. Process according to in any one of Claims 1 to 6, **characterized in that** the respective ends, provided with indents (7B), of two successive intermediate electrode layers (7) of the initial stack (5), lie opposite each other.
